# FASCICULE DE BREVET EUROPEEN

(11) **EP 3 125 375 B1**
(45) Date de publication et mention de la délivrance du brevet: **11.08.2021**
(21) Numéro de dépôt: 16181284.7
(22) Date de dépôt: 26.07.2016
(51) Int. Cl.: G01R 31/00, G01R 31/60, H01R 29/00

(54) **DISPOSITIF AMÉLIORÉ DE RACCORDEMENT D'UN PREMIER FAISCEAU DE CONDUCTEURS BRANCHÉS ALÉATOIREMENT À UN FAISCEAU DE CONDUCTEURS IDENTIFIÉS, EN PARTICULIER POUR LE RACCORDEMENT D'UN FAISCEAU D'ATTELAGE, ET SON UTILISATION**
VERBESSERTE VORRICHTUNG ZUM ANSCHLIESSEN EINES ERSTEN BÜNDELS VON LEITERN, DIE NACH ZUFALLSMUSTER AN EIN BÜNDEL VON IDENTIFIZIERTEN LEITERN ANGESCHLOSSEN SIND, INSBESONDERE FÜR DEN ANSCHLUSS EINES KABELSTRANGS, UND IHRE VERWENDUNG
IMPROVED DEVICE FOR CONNECTING A FIRST BUNDLE OF CONDUCTORS CONNECTED RANDOMLY TO A BUNDLE OF IDENTIFIED CONDUCTORS, IN PARTICULAR FOR CONNECTING A COUPLING BUNDLE, AND ITS USE

(30) Priorité: 27.07.2015 FR 1557143
(43) Date de publication de la demande: 01.02.2017
(73) Titulaire: SEF POWER, 77610 Fontenay-Trésigny (FR)
(72) Inventeur: PLAS, Daniel, 77210 AVON (FR)
(74) Mandataire: Casalonga

(56) Documents cités:
- EP-A2- 1 648 054
- EP-A2- 2 034 423
- EP-A2- 2 590 274
- WO-A1-00/60475
- US-A- 3 902 026

## Description

La présente invention concerne, de manière générale, le raccordement d'un premier faisceau de conducteurs à un deuxième faisceau de conducteurs.

Dans une application particulièrement intéressante, l'invention concerne le raccordement d'un faisceau d'attelage à un faisceau de conducteurs pour feux arrière de véhicule automobile.

Comme on le sait, les conducteurs d'un faisceau d'attelage pour véhicule automobile sont généralement identifiés. Tel n'est pas le cas de la configuration des faisceaux de feux arrière qui varie d'un véhicule à l'autre ou lors des évolutions successives d'un même véhicule.

Ainsi, le montage d'un faisceau d'attelage sur un faisceau arrière de véhicule automobile oblige à identifier les conducteurs du faisceau de feux arrière afin de les raccorder correctement au faisceau d'attelage.

Les installateurs doivent ainsi tout d'abord consulter un document technique spécifique pour chaque véhicule pour identifier les conducteurs du faisceau de feux arrière, ce qui engendre une perte de temps non négligeable.

Pour pallier cet inconvénient, il a été proposé d'utiliser un boîtier de raccordement destiné à être raccordé, d'une part, en entrée, au faisceau de feux arrière et, d'autre part, en sortie, au faisceau d'attelage et comprenant des entrées adressables et des moyens d'adressage destinés à sélectionner des commandes pour identifier le conducteur du faisceau d'attelage correspondant à la commande sélectionnée, après acquittement de cette dernière, et à adresser les entrées après identification des conducteurs.

Après identification des conducteurs de l'ensemble des faisceaux, le boîtier de raccordement est configuré de manière à faire correspondre l'ensemble des conducteurs du faisceau d'attelage avec les conducteurs de feux arrière.

On pourra à cet égard se référer au document EP-A-1 648 054.

Bien qu'un tel boîtier de raccordement soit avantageux à maints égards, il a été constaté que les évolutions des technologies embarquées dans les véhicules automobiles tendent de plus en plus à diversifier les signaux adressés aux feux arrière.

Il a en particulier été constaté que plusieurs signaux différents peuvent être véhiculés sur un même conducteur.

De même, pour un même véhicule, les signaux correspondant à une fonction d'éclairage peuvent avoir des caractéristiques qui varient. Il peut par exemple arriver que les constructeurs de véhicule automobile modifient la fréquence d'un signal lié à l'exécution d'une fonction.

US 3 902 026 A divulgue un système pour identifier un fil parmi un faisceau de fils.

Le but de l'invention est donc de pallier ces divers inconvénients.

Un autre but de l'invention est de proposer un dispositif de raccordement de faisceaux de conducteurs capables de faciliter la reconnaissance des conducteurs et, par conséquent, de rendre plus aisée la mise en correspondance d'un faisceau d'attelage à un faisceau de feux arrière de véhicule automobile.

L'invention a ainsi pour objet, selon la revendication 1, un dispositif de raccordement d'un premier faisceau de conducteurs branchés aléatoirement à un deuxième faisceau de conducteurs identifiés, comprenant un boîtier venant se raccorder entre le premier et le deuxième faisceaux.

Ce dispositif comporte des moyens pour identifier les conducteurs du premier faisceau à partir de caractéristiques des signaux qu'ils véhiculent et des moyens pour diriger les conducteurs identifiés vers des conducteurs correspondants du deuxième faisceau.

Un tel dispositif est ainsi capable de reconnaître les conducteurs du premier faisceau, en l'espèce les conducteurs d'un faisceau de feux arrière de véhicule et ce, par simple comparaison avec des caractéristiques de signaux connus et stockés en mémoire.

Ainsi, selon l'invention, les moyens pour identifier les conducteurs comportent des moyens pour mémoriser les signaux et des moyens pour comparer les signaux mémorisés avec des signaux d'identification stockés en mémoire et correspondant à des fonctions prédéterminées.

On prévoira avantageusement que les moyens de comparaison sont adaptés pour comparer les signaux mesurés avec les signaux d'identification de manière à identifier les signaux mesurés avec une marge de tolérance.

On peut ainsi identifier les conducteurs à partir des signaux qu'ils véhiculent dans diverses phases de roulage ou d'arrêt du véhicule.

Par exemple, le dispositif comporte un microcontrôleur comprenant lesdits moyens de comparaison et ladite mémoire et un étage de puissance recevant des ordres de commande délivrés par les moyens de comparaison pour véhiculer les signaux identifiés vers les signaux correspondants du deuxième faisceau.

Dans un mode de réalisation particulier, le boîtier comporte des entrées adressables raccordées au premier faisceau et des moyens d'adressage des entrées adressables pour diriger les faisceaux identifiés vers les conducteurs correspondants du deuxième faisceau.

Par exemple, les moyens d'adressage comportent une interface homme-machine pour sélectionner des commandes et adaptée pour assigner des entrées aux sorties du boîtier.

Par ailleurs, on pourra avantageusement prévoir que le dispositif comprenne des moyens pour identifier périodiquement les conducteurs du premier faisceau à partir de caractéristiques des signaux qu'ils véhiculent.

D'autres buts, caractéristiques et avantages de l'invention apparaîtront à la lecture de la description suivante, donnée uniquement à titre d'exemple non limitatif et faite en référence aux dessins annexés sur lesquels :
- la figure 1 illustre un exemple de réalisation d'un dispositif de raccordement conforme à l'invention ;
- la figure 2 est un schéma synoptique du dispositif de la figure 1 ; et
- la figure 3 illustre le fonctionnement d'un dispositif de raccordement selon un mode de réalisation particulier, pour le raccordement d'un faisceau d'attelage à un faisceau de feux arrière de véhicule automobile.

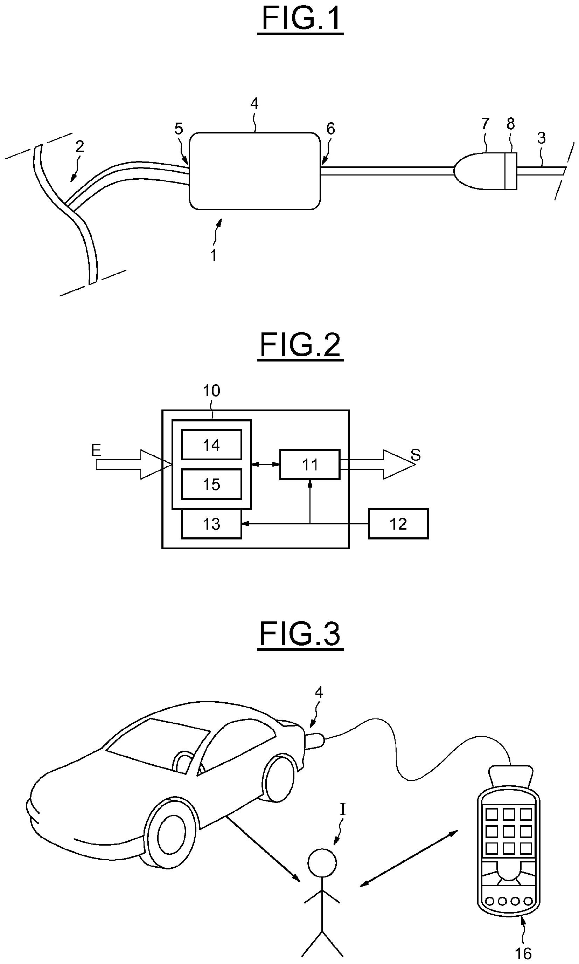

Sur la figure 1, on a représenté l'architecture générale d'un dispositif de raccordement pour faisceaux de conducteurs, désigné par la référence numérique générale 1.

Ce dispositif est destiné à permettre le raccordement d'un premier faisceau 2 de conducteurs à un deuxième faisceau 3 de conducteurs.

Il s'agit respectivement, dans le cadre de la présente description, d'un faisceau de feux arrière de véhicule automobile et d'un faisceau d'attelage, c'est-à-dire un faisceau de conducteurs destinés à être raccordés à un attelage.

Le dispositif 1 constitue un boîtier qui vient se brancher entre le premier faisceau 2 et le deuxième faisceau 3 de conducteurs et est destiné à permettre l'affectation des conducteurs du premier faisceau 2, qui sont branchés aléatoirement, aux conducteurs de l'autre faisceau, préalablement identifiés, pour les faire correspondre sans identifier préalablement, de manière manuelle, les faisceaux du premier faisceau de conducteurs 2.

Le dispositif 1 comporte essentiellement un boîtier de raccordement 4 comprenant un ensemble d'entrées 5 sur lesquelles viennent se brancher les conducteurs du premier faisceau 2 et une sortie 6 équipée d'une prise 7 venant se brancher sur une prise correspondante 8 du faisceau d'attelage 3.

En se référant à la figure 2, le boîtier de raccordement 4 comporte, intérieurement, un étage 10 d'entrée et de commande et un étage de puissance 11 recevant des signaux de commande délivrés par l'étage d'entrée et de commande 10.

Comme on le voit, un étage d'alimentation générale 12 assure l'alimentation de l'étage de puissance 11 ainsi que de l'étage d'entrée et de commande 10 par l'intermédiaire d'un étage d'alimentation secondaire 13.

L'étage d'entrée et de commande 10 comporte un microcontrôleur 14 assurant la détection proprement dite des fonctions des conducteurs du faisceau de feux arrière, associé à une mémoire 15.

Le microcontrôleur 14 reçoit, en entrée E, les signaux véhiculés par chacun des conducteurs.

Lors du fonctionnement du boîtier en mode d'identification des conducteurs, le microcontrôleur 14 assure la mémorisation des signaux véhiculés et assure la comparaison de ces signaux avec des signaux correspondants stockés en mémoire 15. Par exemple, on compare les caractéristiques des signaux reçus en entrée avec les caractéristiques correspondantes des signaux mémorisés dont la fonction est connue.

Il peut par exemple s'agir d'identifier les signaux du faisceau de feu arrière reçus en entrée et qui correspondent à une fonction veilleuse, une fonction clignotant gauche, une fonction clignotant droit, une fonction antibrouillard,...

Après identification des signaux, le microcontrôleur 10 transmet des signaux de commande à l'étage de puissance 11 qui, par exemple, comporte des éléments de circuit configurables, dotés de relais assurant la commutation de la puissance vers l'attelage, de manière à transmettre les signaux identifiés vers les conducteurs du faisceau d'attelage qui assurent la fonction identifiée.

Le boîtier est ainsi capable d'identifier les signaux qu'il reçoit en entrée afin de pouvoir les router vers les sorties correspondantes. Il est en outre capable de séparer des signaux différents véhiculés sur un même conducteur et correspondant à des fonctions différentes.

Les sorties peuvent ainsi être activées sélectivement en fonction des conducteurs d'entrée.

Par exemple, certains véhicules automobiles disposent d'une ou plusieurs ampoules pouvant avoir plusieurs fonctions. Il peut s'agir d'une fonction veilleuse, d'une fonction de stop et d'une fonction antibrouillard. Ces fonctions sont réalisées à partir de trois niveaux de signaux différents.

Sur d'autres véhicules, certains feux, qui sont placés dans le hayon, se déplacent vers le pare-chocs lorsque le hayon est ouvert. Dans ce cas, l'ampoule prévue au niveau du pare-chocs change de fonction et passe ainsi de la fonction antibrouillard à la fonction veilleuse-stop.

La détection des signaux véhiculés et leur comparaison avec des signaux correspondants stockés en mémoire permet ainsi d'identifier la fonction, qu'elle soit combinée avec d'autres fonctions au sein d'une même ampoule ou qu'elle soit déportée vers une autre ampoule.

Par ailleurs, dans le mode de réalisation qui vient d'être décrit, le raccordement d'un premier faisceau de conducteurs branchés aléatoirement, en l'espèce un faisceau de feu arrière d'un véhicule automobile, à un deuxième faisceau de conducteurs identifiés, ici un faisceau d'attelage, consiste à identifier les conducteurs du premier faisceau à partir de caractéristiques des signaux qu'ils véhiculent, par mémorisation et comparaison des signaux reçus en entrée du boîtier avec des signaux mémorisés.

Toutefois, on ne sort pas du cadre de l'invention lorsque les signaux sont véhiculés dans une porteuse simultanément avec des signaux servant à la transmission d'informations de diverses natures, concernant par exemple la pression des pneus, les signaux étant alors démodulés pour être ensuite comparés avec des signaux stockés en mémoire.

On notera par ailleurs que lors du fonctionnement normal du boîtier, on pourra mettre en œuvre des phases périodiques de reconnaissance des signaux d'entrée afin de répondre à des éventuelles évolutions des véhicules, par exemple lors du démarrage.

La reconnaissance des signaux s'effectue en positionnant le boîtier 4 dans un mode d'identification. Il peut, par exemple, s'agir de positionner une entrée spécifique du boîtier à un niveau de tension prédéterminé, par exemple égal à 12 volts, pendant une durée prédéterminée.

On ne sort pas davantage du cadre de l'invention lorsque l'on procède à un adressage des entrées 5 du boîtier 4 en fonction de la nature des signaux qui ont été identifiés. Cet adressage peut également être réalisé de manière périodique.

Il s'agit en d'autres termes de programmer les entrées de manière à les faire correspondre aux sorties du boîtier. Un tel adressage constitue une procédure à la portée d'un homme du métier. Elle ne sera donc pas décrite en détails par la suite.

On notera cependant qu'elle consiste essentiellement à affecter à une ou plusieurs sorties du boîtier une ou plusieurs entrées connectées aléatoirement mais dont la fonction a été identifiée.

Le boîtier peut ainsi comporter des moyens d'adressage des entrées servant à mettre en communication chaque entrée sur laquelle circule un signal identifié avec une sortie correspondante du boîtier 4.

En référence à la figure 3, on pourra à cet égard utiliser un boîtier 16 de configuration qui vient se raccorder au boîtier 4 et incluant des fonctions permettant d'activer ou désactiver des fonctions du véhicule. Le signal ainsi élaboré, en réponse, est détecté et identifié par le boîtier 4 qui, en réponse, procède à un adressage de l'entrée correspondante pour router le signal identifié vers la sortie correspondante du boîtier 4 et, par conséquent, le conducteur correspondant du faisceau d'attelage 3.

## Revendications

1. Dispositif de raccordement d'un premier faisceau de conducteurs branchés aléatoirement à un deuxième faisceau de conducteurs identifiés, comprenant un boîtier (4) venant se raccorder entre le premier et le deuxième faisceaux (2, 3), **caractérisé en ce qu'**il comporte des moyens pour identifier les conducteurs du premier faisceau à partir de caractéristiques des signaux qu'ils véhiculent et des moyens pour mettre en communication les conducteurs identifiés vers des conducteurs correspondants du deuxième faisceau,
et dans lequel les moyens pour identifier les conducteurs comportent des moyens pour mémoriser les signaux et des moyens pour comparer les signaux mémorisés avec des signaux d'identification stockés en mémoire et correspondant à des fonctions prédéterminées.

2. Dispositif selon la revendication 1, dans lequel les moyens de comparaison sont adaptés pour comparer les signaux mesurés avec les signaux d'identification de manière à identifier les signaux mesurés avec une marge de tolérance.

3. Dispositif selon l'une des revendications 1 et 2, comprenant un microcontrôleur comprenant lesdits moyens de comparaison et un étage de puissance recevant des ordres de commande délivrés par les moyens de comparaison pour véhiculer les signaux identifiés vers les signaux correspondants du deuxième faisceau.

4. Dispositif selon l'une des revendications 1 et 2, dans lequel le boîtier comporte des entrées adressables raccordées au premier faisceau et des moyens d'adressage des entrées adressables pour diriger les conducteurs identifiés vers les conducteurs correspondants du deuxième faisceau.

5. Dispositif selon la revendication 4, dans lequel les moyens d'adressage comportent une interface homme-machine pour sélectionner des commandes et adaptée pour assigner des entrées aux sorties du boîtier.

6. Dispositif selon l'une quelconque des revendications 1 à 5, comprenant des moyens pour identifier périodiquement les conducteurs du premier faisceau à partir de caractéristiques des signaux qu'ils véhiculent.

7. Utilisation d'un dispositif selon l'une quelconque des revendications 1 à 6, pour le raccordement d'un faisceau de feu arrière de véhicules automobiles.

## Patentansprüche

1. Vorrichtung zum Anschließen eines ersten Bündels von Leitern, die nach Zufallsmuster an ein zweites Bündel von identifizierten Leitern angeschlossen werden, umfassend ein zwischen dem ersten und dem zweiten Bündel (2, 3) in Anschluss kommendes Gehäuse (4), **dadurch gekennzeichnet, dass** sie Mittel aufweist, um die Leiter des ersten Bündels auf der Basis von Eigenschaften der Signale, die sie befördern, zu identifizieren, und Mittel, um die identifizierten Leiter zu den entsprechenden Leitern des zweiten Bündels in Kommunikation zu versetzen,
und wobei die Mittel zum Identifizieren der Leiter Mittel aufweisen, um die Signale zu speichern und Mittel, um die gespeicherten Signale mit im Speicher gespeicherten Identifikationssignalen und die vorher festgelegten Funktionen entsprechen, zu vergleichen.

2. Vorrichtung nach Anspruch 1, wobei die Vergleichsmittel geeignet sind, die gemessenen Signale mit den Identifikationssignalen derart zu vergleichen, dass die gemessenen Signale mit einer Toleranzmarge identifiziert werden.

3. Vorrichtung nach einem der Ansprüche 1 und 2, umfassend einen Mikrocontroller, umfassend die Vergleichsmittel und eine Leistungsstufe, die Steuerbefehle empfängt, die von den Vergleichsmitteln bereitgestellt werden, um die identifizierten Signale zu den entsprechenden Signalen des zweiten Bündels zu befördern.

4. Vorrichtung nach einem der Ansprüche 1 und 2, wobei das Gehäuse adressierbare Eingänge aufweist, die an das erste Bündel angeschlossen sind, und Adressierungsmittel der adressierbaren Eingänge, um die identifizierten Leiter zu den entsprechenden Leitern des zweites Bündels zu lenken.

5. Vorrichtung nach Anspruch 4, wobei die Adressierungsmittel eine Mensch-Maschine-Schnittstelle aufweisen, um Befehle auszuwählen und die geeignet ist, um Eingänge den Ausgängen des Gehäuses zuzuordnen.

6. Vorrichtung nach einem der Ansprüche 1 bis 5, umfassend Mittel, um die Leiter des ersten Bündels auf der Basis von Eigenschaften der Signale, die sie befördern, periodisch zu identifizieren.

7. Verwendung einer Vorrichtung nach einem der Ansprüche 1 bis 6 für den Anschluss eines Rücklichtbündels von Kraftfahrzeugen.

## Claims

1. A device for connecting a first bundle of conductors randomly connected to a second bundle of identified conductors, comprising a casing (4) which is connected between the first and the second bundles (2, 3), **characterised in that** it includes means for identifying the conductors of the first bundle from features of the signals which they convey and means for communicating the identified conductors with corresponding conductors of the second bundle,
and wherein the means for identifying the conductors include means for memorising the signals and means for comparing the memorised signals with identification signals stored in memory and corresponding to predetermined functions.

2. The device according to claim 1, wherein the comparison means are adapted to compare the measured signals with the identification signals so as to identify the measured signals with a margin of tolerance.

3. The device according to one of claims 1 and 2, comprising a microcontroller comprising said comparison means and a power stage receiving control commands delivered by the comparison means to convey the identified signals to the corresponding signals of the second bundle.

4. The device according to one of claims 1 and 2, wherein the casing includes addressable inputs connected to the first bundle and means for addressing addressable inputs to direct the identified conductors to the corresponding conductors of the second bundle.

5. The device according to claim 4, wherein the addressing means include a man-machine interface for selecting controls and adapted to assign inputs to the outputs of the casing.

6. The device according to any one of claims 1 to 5, comprising means for periodically identifying the conductors of the first bundle from features of the signals which they convey.

7. A use of a device according to any one of claims 1 to 6, for connecting a rear light bundle of motor vehicles.
